Europäisches Patentamt

European Patent Office

Office européen des brevets

(11) Publication number: **0 220 578**
**A2**

## (12) EUROPEAN PATENT APPLICATION

(21) Application number: **86114063.0**

(22) Date of filing: **10.10.86**

(51) Int. Cl.4: **G03F 7/02** , G03F 7/08 , G03F 7/10

(30) Priority: **24.10.85 US 790906**

(43) Date of publication of application:
**06.05.87 Bulletin 87/19**

(84) Designated Contracting States:
**DE FR GB IT**

(71) Applicant: **International Business Machines Corporation**
**Old Orchard Road**
**Armonk, N.Y. 10504(US)**

(72) Inventor: **Hinsberg, William Dinan**
**40635 Ladero Street**
**Freemont California 94539(US)**
Inventor: **Willson, Carlton Grant**
**1982 University Avenue**
**San Jose California 95126(US)**

(74) Representative: **Hobbs, Francis John**
**IBM United Kingdom Limited Intellectual**
**Property Department Hursley Park**
**Winchester Hampshire SO21 2JN(GB)**

(54) A photoresist composition and a process using that photoresist composition.

(57) A photoresist composition comprising a matrix resin and two photoactive additives, one of which causes acceleration of dissolution upon irradiation and one of which causes deceleration of dissolution upon irradiation, the photoactive additives being such that the dissolution-accelerating additive is activated by at least one narrow bandwidth of radiation which does not activate the dissolution-decelerating additive. Self aligned multilayer or multi-level structures can be made by a process using that photoresist composition.

# A PHOTORESIST COMPOSITION AND A PROCESS USING THAT PHOTORESIST COMPOSITION

This invention relates to a photoresist composition and a process which uses that photoresist composition for producing self-aligned structures.

Resists commonly used in photolithography are comprised of a polymeric matrix resin and may include a radiation-sensitive additive which modifies the dissolution of the resist upon activation by radiation. These resists commonly generate either a positive or a negative-tone image of the mask upon activation dependent on the nature of the resist composition. There are several examples of resists that can be used to generate both positive and negative tone images depending on the process employed. These include such resists as t-BOC (US-A-4,491,628) and the MIRP resist (US-A-4,104,070). With such resists it is not practical to bring about imaging in both positive and negative tone simultaneously without two separate and distinct lithographic patterning steps.

According to the invention, a photoresist composition comprises a matrix resin and two photoactive additives, one of which causes acceleration of dissolution upon irradiation and one of which causes deceleration of dissolution upon irradiation, the photoactive additives being such that the dissolution-accelerating additive is activated by at least one narrow bandwidth of radiation which does not activate the dissolution-decelerating additive.

This dual tone resist, when exposed at the bandwidth that activates only the rate-accelerating component, acts as a common positive tone photoresist. When exposed to wavelengths that activate either the rate-decelerating compound alone, or the decelerating and the accelerating compounds together, the composition behaves as a negative photo resist. When this dual tone resist is exposed through a mask having the following imaging elements: an area that is opaque to all active bandwidths, an area that is transparent to all active bandwidths, and an area that is transparent to the bandwidth which activates the accelerating additive and opaque to the bandwidth which activates the decelerating additive (hereafter called the optical filter element), and then developed in dilute aqueous base in the fashion well-known in the art, a positive tone relief image is formed of the pattern of optical filter elements on the mask. The resulting relief image can be used for the usual purposes, i.e, etching, deposition and implantation. When the resulting structure is flood-exposed with radiation of a bandwidth that activates only the accelerating additive and does not activate the decelerating additive, and subjected to a second development step analogous to the first, a second relief image is generated corresponding to the pattern of mask elements that are opaque to all activating bandwidths of radiation, and this relief image is aligned to the first exactly according to their positional relationship on the mask.

In a preferred embodiment of the present invention, the composition is sensitive to various wavelengths of ultraviolet light. For example, the additive that brings about acceleration of resist dissolution upon activation can be diazonaphthoquinone sulfonate esters that absorb at wavelengths up to 400 to 450 nanometres. The decelerating additive can be mono-or bis-azides that do not absorb at wavelengths above 320 nanometres. The mask can be fabricated on a quartz substrate that transmits all wavelengths above 200 nanometres. The opaque mask elements can be chromium that is opaque to all activating wavelengths. The optical filter elements can be films of a common positive diazonaphthoquinone-novolac photoresist such as those commonly used in microcircuit fabrication, which transmit above 350 nanometres and are opaque below 350 nanometres at thicknesses greater than 3 microns.

The preferred matrix polymers for the resist formulation are any weakly acidic polymeric materials commonly useful for positive photoresist application. These include but are not limited to cresol novolacs, poly(p-hydroxystyrene) and acidic acrylic resins.

The preferred photoactive additives that accelerate resist dissolution upon activation include, but are not limited to, 4-or 5-sulfonate esters of 1-oxo-2-diazonaphthoquinone sulfonic acids, 2,2-dimethyl-4,6-dioxo-1-3-dioxolane and related compounds, and o-nitrobenzyl esters of carboxylic acids.

The preferred photoactive additives that decelerate resist dissolution upon activation are mono-or bis-aryl azides including, but not restricted to diazidodiphenyl sulfones, bis-(azidobenzylidene)-cyclohexanones and azidochalcones.

How the invention can be carried out will now be described by way of example, with reference to the accompanying diagrammatic drawing which represents successive steps in forming a relief profile in a substrate.

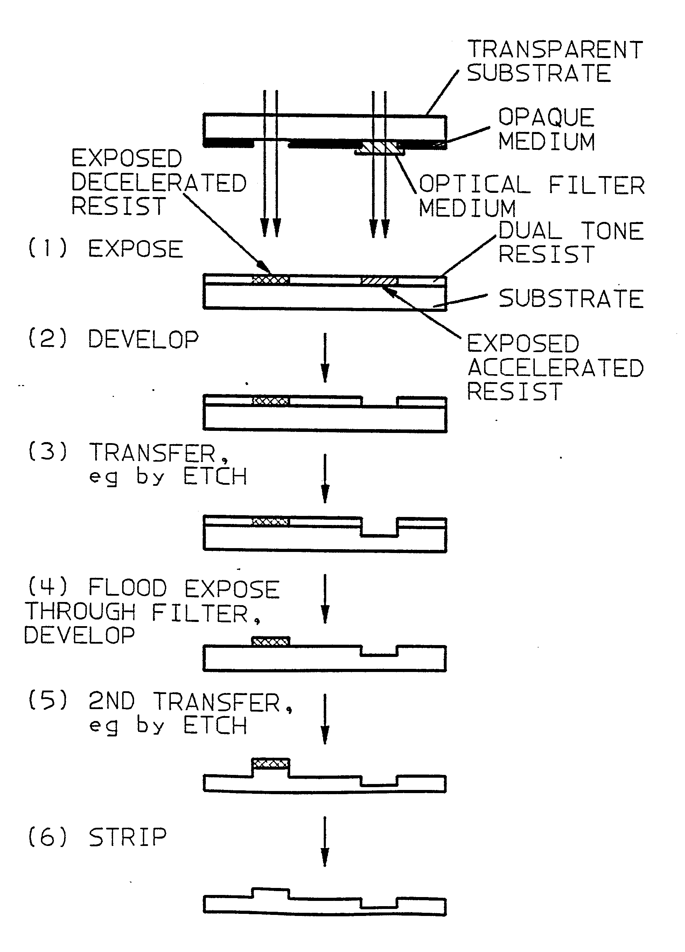

In the process represented in the accompanying drawing, a resist layer is exposed through a mask having, for example, some completely transparent areas and some areas transparent to only near ultraviolet. The resist layer is disposed on a substrate which is to be profiled. The resist has two additives in it, one of which accelerates dissolution upon irradiation, and one of which decelerates dissolution upon irradiation.

The resist is then developed. The relief image is then transferred to the substrate, for example, by etching. The resist is then flood exposed through a filter, for example, using near ultraviolet light, and developed. Next there is a second image transfer to the substrate, for example, by etching. The resist is finally stripped.

Some preferred examples of processes for using the present invention will now be described.

## Example 1

Formulation of Dual Tone Resist: 250 grams of a cresol novolac resin was dissolved in 583 grams of bis(2-methoxyethyl) ether. To the solution was added 38.1 grams of 3,3'-diazidodiphenyl sulfone and 29.3 grams of 4,8-bis[(6-diazo-5,6-dihydro-5-oxo-1-naphthalenyl)sulfonyloxymethyl]tricyclo-[5.2.10 $^{2,6}$]decane. The mixture was stirred and warmed to 55°C until all components were dissolved, and filtered after cooling.

Fabrication of Dichromatic Mask: A quartz mask blank plated with a chromium film was coated with resist, a pattern of opaque and transparent areas was defined in the chromium film by patterning the resist and etching the exposed metal, and the resist was removed. A film of AZ1375 photoresist, a commercial positive-tone photoresist (product of American Hoechst Corporation) 3.5 microns thick was applied, and was patterned in the conventional manner. The resulting structure was then exposed to ultraviolet light until the transmittance at 400 nanometres of the remaining portions of the AZ1375 film reached a maximum.

A film of the dual tone resist formulated as described above was applied to a ceramic substrate plated with 20 nm of chromium, 8000 nm of copper and 80 nm of chromium, and the resulting structure was baked at 80°C for 20 minutes. The film was exposed through a dichromatic mask prepared as described above, employing a light source whose output includes ultraviolet light with wavelengths greater than 250 nanometres. The film was developed in a 2:1 mixture of Microposit MF312 developer, an aqueous alkaline developer produced by the Shipley Company, and water. The resulting positive tone relief image corresponded to those portions of the mask where radiation was transmitted through the optical filter medium. The chromium on those areas of the ceramic substrate not covered by the patterned resist was etched using a solution of thiourea and sulfuric acid in water, and the underlying copper uncovered by this was etched with an aqueous solution of ferric chloride. The structure was flood exposed to radiation of wavelengths greater than 350 nanometres and was developed in a 1:5 mixture of Microposit 2401 developer, an aqueous alkaline developer produced by the Shipley Company. The positive tone image that resulted from this second development step corresponded to those areas of the dichromatic mask which were opaque. The chromium metal exposed by the second development step was etched with a solution of thiourea and sulfuric acid in water, and the resist was stripped with acetone.

## Example 2

A dual tone resist was prepared as follows: 4.5 grams of a cresol novolac resin was dissolved in 10.6 grams of bis(2-methoxyethyl)ether. To this mixture was added 0.48 grams of 4,8-bis[(6-diazo-5,6-dihydro-5-oxo-1-naphthalenyl)-sulfonyloxymethyl]tricyclo[5.2.10 $^{2,6}$]decane and 0.23 grams of compound R550-09 (a 2,5-bis(azidophenyl)oxazole, (product of Eastman Kodak). The mixture was heated to 55°C until all material was dissolved, and the resulting liquid was filtered after cooling.

A dichromatic mask was prepared as follows: a borosilicate glass mask blank plated with a chromium film was coated with resist, a pattern of opaque and transparent areas was defined in the chromium film by patterning the resist and etching the exposed metal, and the resist was removed. A mixture of 50 grams of 40% solution of positive diazonaphthoquinone-novolac photoresist in bis(2-methoxyethyl)ether and 1.6 grams of 1-naphthaldehyde azine was prepared and applied as a film 5.0 microns thick on the mask. This dyed photoresist layer was patterned and developed in the conventional manner. The resulting structure was then exposed to ultraviolet light until the transmittance at 436 nanometres of the remaining portions of the dyed photoresist film reached a maximum.

A film of the resist described above in this Example was applied to a silicon wafer and baked at 80°C for 20 minutes. The film was exposed through the dichromatic mask described in the paragraph above using a light source with output that includes radiation of wavelengths greater than 350 nanometres. The film was developed in a 1:8 mixture of Micro posit 2401 developer, an aqueous alkaline developer (produced by the Shipley Company), and water. The resulting positive tone relief image corresponded to those portions of the dichromatic mask where radiation was transmitted through the optical filter of dyed resist. The dual tone resist film was then flood exposed to radiation of wavelength 436 nanometres, and developed in a 1:8 dilution of Microposit 2401 developer, an aqueous alkaline developer (produced by the Shipley Company). The positive tone image that resulted from this second development step corresponded to those areas of the mask which were opaque.

## Claims

1. A photoresist composition comprising a matrix resin and two photoactive additives, one of which causes acceleration of dissolution upon irradiation and one of which causes deceleration of dissolution upon irradiation, the photoactive additives being such that the dissolution-accelerating additive is activated by at least one narrow bandwidth of radiation which does not activate the dissolution-decelerating additive.

2. A photoresist composition as claimed in claim 1, wherein the matrix resin is a phenol-formaldehyde resin.

3. A photoresist composition as claimed in claim 1, wherein the matrix resin is p-hydroxystyrene.

4. A photoresist composition as claimed in any preceding claim, wherein the dissolution-accelerating additive is a diazoketone.

5. A photoresist composition as claimed in any of claims 1 to 3, wherein the dissolution-accelerating additive is a 1-oxo-2-diazonaphthoquinone-5-sulfonate ester.

6. A photoresist composition as claimed in any preceding claim, wherein the dissolution-decelerating additive is a mono-or bis-azide.

7. A photoresist composition as claimed in any of claims 1 to 5, wherein the dissolution-decelerating additive is a diazido diphenyl sulfone.

8. A photoresist composition as claimed in any of claims 1 to 5, wherein the dissolution decelerating additive is a monoaryl azide.

9. A photoresist composition as claimed in any of claims 1 to 5, wherein the dissolution-decelerating additive is an azidochalcone.

10. A process for producing self-aligned structures, the process comprising the steps of:

(1) coating a substrate with photoresist composition as claimed in any preceding claim,

(2) exposing said composition to radiation through a mask which has opaque areas and two types of transparent areas, one of which is opaque to the bandwidth that activates the dissolution-decelerating additive,

(3) developing by treatment with a solvent,

(4) transferring the resulting image to the substrate,

(5) flood exposing with radiation of a bandwidth that activates the dissolution-accelerating additive but does not activate the dissolution-decelerating additive,

(6) developing by treatment with a solvent,

(7) transferring the image to the substrate, and

(8) stripping the resist from the substrate.

11. A process as claimed in claim 10, in which the image transfer steps are done by etching.

TRANSPARENT
SUBSTRATE

OPAQUE
MEDIUM

EXPOSED
DECELERATED
RESIST

OPTICAL FILTER
MEDIUM

DUAL TONE
RESIST

(1) EXPOSE

SUBSTRATE

(2) DEVELOP

EXPOSED
ACCELERATED
RESIST

(3) TRANSFER,
eg by ETCH

(4) FLOOD EXPOSE
THROUGH FILTER,
DEVELOP

(5) 2ND TRANSFER,
eg by ETCH

(6) STRIP